# EUROPÄISCHE PATENTSCHRIFT

(11) **EP 1 928 009 B1**
(45) Veröffentlichungstag und Bekanntmachung des Hinweises auf die Patenterteilung: **10.04.2013**
(21) Anmeldenummer: 06024603.0
(22) Anmeldetag: 28.11.2006
(51) Int. Cl.: H01J 37/32

(54) **Bogenentladungs-Erkennungseinrichtung, Plasma-Leistungsversorgung und Verfahren zum Erkennen von Bogenentladungen**
Arc detection system, plasma power supply and arc detection method
Système de détection d'arc, alimentation de puissance pour appareil à plasma et procédé de détection d'arc

(43) Veröffentlichungstag der Anmeldung: 04.06.2008
(73) Patentinhaber: HÜTTINGER Elektronik GmbH + Co. KG, 79111 Freiburg (DE)
(72) Erfinder: Zähringer, Gerhard, 79112 Freiburg (DE)
(74) Vertreter: Kohler Schmid Möbus

(56) Entgegenhaltungen:
- EP-A2- 0 713 242
- WO-A-01/13402
- WO-A-03/088445
- DE-A1- 4 420 951
- US-A- 5 993 615
- US-B1- 6 943 317

## Beschreibung

Die Erfindung betrifft ein Verfahren zum Erkennen von Bogenentladungen in einem Plasmaprozess, bei dem zum Erkennen auftretender Bogenentladungen in dem Plasma eine Kenngröße des Plasmaprozesses überwacht wird, und bei dem nach Erkennen einer Bogenentladung während einer ersten Zeit abgewartet und anschließend die Kenngröße erneut überprüft wird.

Weiterhin betrifft die vorliegende Erfindung eine Bogenentladungs-Erkennungseinrichtung zum Erkennen von Bogenentladungen in einem Plasmaprozess anhand einer Kenngröße des Plasmaprozesses, wobei die Bogenentladungs-Erkennungseinrichtung aufweist: eine Überwachungseinheit zum Überwachen der Kenngröße, die zum Erzeugen und Ausgeben eines Überwachungssignals bei Erkennen einer Bogenentladung ausgebildet ist; eine Timer-Einheit, die zum Bestimmen und Ausgeben einer seit Erzeugung des Überwachungssignals vergangenen Zeit ausgebildet ist; und eine Steuereinheit, die dazu ausgebildet ist, in Abhängigkeit von dem Überwachungssignal und der vergangenen Zeit wenigstens ein Steuersignal zum Steuern einer jeweiligen Gegenmaßnahme zum Unterdrücken der Bogenentladung zu erzeugen.

Darüber hinaus betrifft die vorliegende Erfindung auch eine Plasma-Leistungsversorgung zum Versorgen eines Plasmaprozesses.

Plasmaprozesse kommen beispielsweise in Plasmabearbeitungs- und Beschichtungsvorrichtungen vor. Diese werden wegen des dabei verwendeten Prozesses (Sputtering) und aufgrund der Tatsache, dass eine Gleichspannung zur Erzeugung des Plasmas verwendet wird, auch als Gleichstrom-Sputteranlagen bezeichnet. Bei derartigen Anlagen kommt es oft zu Überschlägen, bei denen sich ein Strom einen elektrisch leitenden Kanal im Plasma sucht. Insbesondere treten derartige Überschläge bei dem so genannten reaktiven Beschichten eines Substrates auf. Ursache hierfür ist der Umstand, dass neben dem Substrat selbst auch Teile der Sputteranlage, wie die Innenwand einer Prozesskammer oder Teile von Blenden, mit elektrisch nicht leitenden oder schlecht leitenden Materialien beschichtet werden, die sich dann bis zu einer Durchbruchspannung aufladen.

Um größeren Schaden von einer Sputteranlage fernzuhalten, wird deshalb die Stromzufuhr der Plasma-Leistungsversorgung nach dem Auftreten eines Überschlags abgeschaltet, oder der Strom wird kurzzeitig unterbrochen. Alternativ kann auch die Spannung an der Plasmakammer kurzgeschlossen oder umgepolt werden. Um die vorstehend genannten Maßnahmen zur Unterdrückung von Bogenentladungen einleiten zu können, sind für die Leistungsversorgung von Plasmaprozessen Einrichtungen zur Bogenentladungs-Erkennung oder Arc-Erkennung sowie zur Löschung der Bogenentladungen erforderlich und bilden oft einen Bestandteil der Plasmastromversorgung.

Bei den erkannten Bogenentladungen oder Arcs kann dabei grundsätzlich zwischen solchen Bogenentladungen unterschieden werden, die selbständig wieder verlöschen (so genannte Short-Arcs), und solchen, die länger andauernd bestehen bleiben und unter Umständen zur vollständigen Zerstörung bzw. Löschung des Plasmas sowie zu einer entsprechenden Beeinträchtigung der verwendeten Anlagen, Substrate usw. führen können (so genannte Hard-Arcs).

Da eine Unterbrechung der Plasma-Leistungsversorgung bzw. ein Umpolen derselben immer mit einer Beeinträchtigung des Durchsatzes des Plasmaprozesses verbunden ist und da es sich bei den erwähnten Short-Arcs um selbstverlöschende Bogenentladungen handelt, ist es eine weit verbreitete Ansicht, dass beim Betreiben eines Plasmaprozesses hinsichtlich Short-Arcs vorteilhafter Weise keine Gegenmaßnahmen ergriffen werden sollten. Da jedoch auch selbstverlöschende Arcs sich negativ auf ein Bearbeitungsergebnis des Plasmaprozesses auswirken und sich darüber hinaus ohne entsprechende Gegenmaßnahmen zu Hard-Arcs entwickeln können, hat sich ein derartiger Ansatz als nachteilig erwiesen.

Bei dem vorbekannten Verfahren ist demnach Insbesondere als nachteilig anzusehen, dass auf selbstverlöschende Bogenentladungen überhaupt nicht reagiert wird. Wie bereits vorstehend angesprochen, ist dies mit den steigenden Anforderungen an Überarbeitungsqualität bei Plasmaprozessen, beispielsweise an die Qualität einer Beschichtung, nicht vereinbar.

Wenn eine Reaktion auf Short-Arcs jedoch in genau derselben Weise hinsichtlich Dauer und Intensität erfolgte wie bei Hard-Arcs, die naturgemäß häufig stärkere Gegenmaßnahmen erfordern, wäre die Plasma-Leistungsversorgung während unangemessen langer Zeiträume nicht aktiv, was zu einer deutlichen Verringerung der Bearbeitungsrate führen würde.

Aus der US 6,943,317 B1 ist es bekannt, bei Erkennen eines Arcs den von einer Leistungsversorgung kommenden Strom umzuleiten, um dadurch zu verhindern, dass Energie von der Leistungsversorgung in ein Plasma gelangt. Ein Arcableiter ist zu diesem Zweck an den Ausgang der Leistungsversorgung angeschlossen. Der Strom wird bei Erkennen eines Arcs für eine erste vorgegebene Zeit umgeleitet. Der Arcableiter wird erneut aktiviert, wenn nach Ablauf einer zweiten vorgegebenen Zeit der Arc noch nicht erloschen ist.

Der Erfindung liegt die Aufgabe zugrunde, ein Verfahren, eine Bogenentladungs-Erkennungseinrichtung und eine Plasma-Leistungsversorgung der jeweils eingangs genannten Art dahingehend weiterzuentwickeln, dass sie steigenden Anforderungen an die Bearbeitungsqualität gerecht werden, ohne dass eine Bearbeitungsrate über Gebühr beeinträchtigt würde.

Gemäß einem ersten Aspekt der vorliegenden Erfindung wird diese Aufgabe bei einem Verfahren der eingangs genannten Art dadurch gelöst, dass als Reaktion auf den Fall, dass nach Ablauf der ersten Zeit keine Bogenentladung erkannt wird, eine erste Gegenmaßnahme zum Unterdrücken von Bogenentladungen durchgeführt wird.

Gemäß einem zweiten Aspekt der vorliegenden Erfindung wird die Aufgabe bei einer Bogenentladungs-Erkennungseinrichtung der eingangs genannten Art dadurch gelöst, dass die Steuereinheit dazu ausgebildet ist, ein erstes Steuersignal zum Veranlassen einer ersten Gegenmaßnahme zu erzeugen, wenn die Überwachungseinheit das Überwachungssignal für das Erkennen der Bogenentladung nach Ablauf einer ersten vorgegebenen Zeit nicht mehr ausgibt.

Gemäß einem dritten Aspekt der vorliegenden Erfindung wird die Aufgabe bei einer Plasma-Leistungsversorgung der genannten Art gelöst durch eine Bogenentladungs-Erkennungseinrichtung nach dem zweiten Aspekt der vorliegenden Erfindung, wobei die Plasma-Leistungsversorgung durch die Steuereinheit der Bogenentladungs-Erkennungseinrichtung steuerbar ist.

Entsprechend ist in Weiterbildung des erfindungsgemäßen Verfahrens vorgesehen, dass das Verfahren zum Steuern des Betriebs einer Plasma-Leistungsversorgung eingesetzt wird.

Nach einem Grundgedanken der vorliegenden Erfindung wird somit auch im Falle von selbstverlöschenden Bogenentladungen eine (erste) Gegenmaßnahme zum Unterdrücken von Bogenentladungen bewirkt, wodurch die Erfindung steigenden Anforderungen an die Bearbeitungsqualität bei Plasmaprozessen gerecht wird. Allerdings wird eine derartige Gegenmaßnahme erfindungsgemäß nur dann vorgenommen oder eingeleitet, wenn zuvor tatsächlich eine (selbstverlöschende) Bogenentladung erkannt wurde.

Bei der überwachten Kenngröße kann es sich in Weiterbildung sowohl des erfindungsgemäßen Verfahrens als auch der erfindungsgemäßen Bogenentladungs-Erkennungseinrichtung um eine elektrische Kenngröße handeln, wie eine Spannung oder eine Stromstärke.

In Weiterbildung des erfindungsgemäßen Verfahrens ist vorgesehen, dass als erste Gegenmaßnahme ein Unterbrechen oder ein Umpolen der Plasma-Leistungsversorgung durchgeführt wird. Dabei kann die erste Gegenmaßnahme insbesondere während einer zweiten Zeit durchgeführt werden.

Im Zuge einer entsprechenden Ausgestaltung der erfindungsgemäßen Plasma-Leistungsversorgung ist vorgesehen, dass als erste Gegenmaßnahme nach Maßgabe des ersten Steuersignals die Plasma-Leistungsversorgung während einer bestimmten Zeit abschaltbar oder umpolbar ist, insbesondere während der zweiten Zeit.

Um - wie gesagt - eine möglichst geringe Beeinträchtigung der Bearbeitungsrate des Plasmaprozesses zu gewährleisten, sieht eine andere Weiterbildung des erfindungsgemäßen Verfahrens vor, dass die erste Gegenmaßnahme zur Unterdrückung/Löschung von Short-Arcs nur kurzzeitig durchgeführt wird, d.h. dass die zweite Zeit zwischen 0,1 und 10 µs beträgt.

Gemäß einer entsprechenden Weiterbildung der erfindungsgemäßen Bogenentladungs-Erkennungseinrichtung ist vorgesehen, dass die zweite Zeit einstellbar ist und insbesondere zwischen 0,1 und 10 µs beträgt.

Um die Betriebssicherheit des erfindungsgemäßen Verfahrens beim Vorliegen eines Hard-Arcs zu gewährleisten, sieht eine andere Ausgestaltung des erfindungsgemäßen Verfahrens vor, dass in dem Fall, dass nach Ablauf der ersten Zeit weiterhin eine Bogenentladung erkannt wird, eine zweite Gegenmaßnahme zum Unterdrücken von Bogenentladungen durchgeführt wird. Somit kann auf Hard-Arcs wie gewohnt mit einer entsprechenden, d.h. relativ langen Abschalt- bzw. Umpolzeit reagiert werden.

Eine entsprechende Ausgestaltung der erfindungsgemäßen Bogenentladungs-Erkennungseinrichtung sieht vor, dass die Steuereinheit dazu ausgebildet ist, ein zweites Steuersignal für eine zweite Gegenmaßnahme zu erzeugen, wenn die Überwachungseinheit das Überwachungssignal für das Erkennen der Bogenentladung nach Ablauf der ersten Zeit weiterhin ausgibt.

Vorteilhafter Weise kann demgemäß bei einer Ausgestaltung des erfindungsgemäßen Verfahrens vorgesehen sein, dass als zweite Gegenmaßnahme ein Unterbrechen oder ein Umpolen der Plasma-Leistungsversorgung durchgeführt wird, wobei die zweite Gegenmaßnahme im Zuge einer anderen Weiterbildung des erfindungsgemäßen Verfahrens während einer dritten Zeit durchgeführt wird. In diesem Zusammenhang sieht eine weitere Ausgestaltung des erfindungsgemäßen Verfahrens vor, dass die dritte Zeit länger als die zweite Zeit ist und vorzugsweise mehr als 10 µs beträgt.

Eine entsprechende Weiterbildung der erfindungsgemäßen Plasma-Leistungsversorgung sieht vor, dass als zweite Gegenmaßnahme nach Maßgabe des zweiten Steuersignals die Plasma-Leistungsversorgung während einer weiteren vorbestimmten Zeit abschaltbar oder umpolbar ist, insbesondere während der dritten Zeit. Dabei kann die dritte Zeit in Weiterbildung der erfindungsgemäßen Bogenentladungs-Erkennungseinrichtung einstellbar sein, insbesondere auf Werte größer als die zweite Zeit.

Gemäß einer anderen Ausgestaltung des erfindungsgemäßen Verfahrens kann vorgesehen sein, dass während der ersten Zeit keine Reaktion auf weitere erkannte Bogenentladungen erfolgt. Treten nämlich während der Zeit nach dem Erkennen einer ersten Bogenentladung bis zum Ablauf der genannten ersten Zeit noch weitere Bogenentladungen auf, brauchen diese erfindungsgemäß nicht berücksichtigt zu werden. Sollte nämlich - wie vorstehend beschrieben - nach Ablauf der ersten Zeit die Bogenentladung noch immer anliegen, wird diese ohnehin als Hard-Arc behandelt und mit einer entsprechend angepassten starken Gegenmaßnahme unterdrückt. Wenn jedoch die erste bekannte Bogenentladung nach Ablauf der ersten Zeit nicht mehr anliegt, bereinigt das gemäß einer Ausgestaltung der vorliegenden Erfindung vorgesehene kurze Abschalten bzw. Umpolen (d.h. die erste Gegenmaßnahme) auch alle "Unreinheiten" der zwischenzeitlich weiter aufgetretenen Bogenentladungen.

Um das erfindungsgemäße Verfahren hinsichtlich des Bearbeitungsdurchsatzes weiter zu verbessern, kann in Weiterbildung des erfindungsgemäßen Verfahrens auch vorgesehen sein, dass während einer vierten Zeit ab Erkennen der Bogenentladung keine weiteren ersten Gegenmaßnahmen durchgeführt werden, wobei die vierte Zeit vorzugsweise länger ist als die erste Zeit.

Entsprechend kann in Weiterbildung der erfindungsgemäßen Bogenentladungs-Erkennungseinrichtung vorgesehen sein, dass die Steuereinheit dazu ausgebildet ist, das erste Steuersignal vor Ablauf einer vierten Zeit ab Erkennen einer Bogenentladung nicht erneut zu erzeugen. Dabei ist die vierte Zeit vorteilhafter Weise einstellbar, insbesondere auf Werte größer als die erste Zeit. Durch das Vorgeben bzw. Einstellen der weiteren, vierten Zeit, innerhalb derer auf mehrere (zusätzlich) erkannte Short-Arcs nicht reagiert wird, lässt sich die Bearbeitungsrate des Plasmaprozesses weiter erhöhen.

Bevorzugte Ausführungsbeispiele der Erfindung sind in der Zeichnung schematisch dargestellt und werden nachfolgend mit Bezug zu den Figuren der Zeichnung näher erläutert. Es zeigt:
- **Fig. 1**: ein schematisches Blockschaltbild einer Ausgestaltung der erfindungsgemäßen Leistungsversorgung für einen Plasmaprozess;
- **Fig. 2**: ein Zeitablaufdiagramm für Signale innerhalb der Plasma-Leistungsversorgung aus Fig. 1; und
- **Fig.3**: ein Flussdiagramm zur Darstellung einer Ausgestaltung des erfindungsgemäßen Verfahrens zum Erkennen von Bogenentladungen.

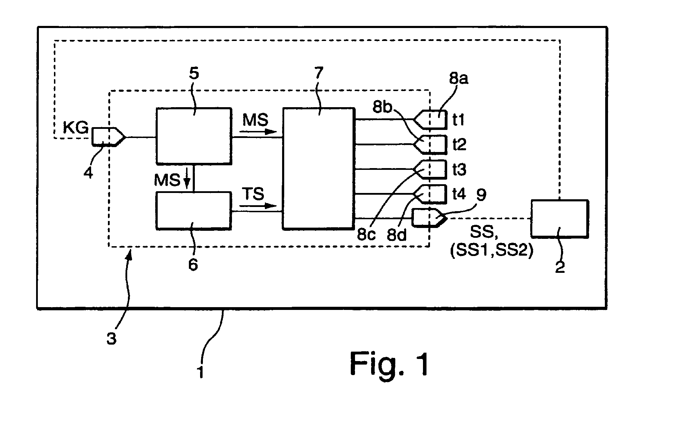

Fig. 1 zeigt ein schematisches Blockschaltbild einer Ausgestaltung der erfindungsgemäßen Leistungsversorgung für einen Plasmaprozess (Plasma-Leistungsversorgung). Die Plasma-Leistungsversorgung 1 gemäß Fig. 1 weist zunächst die eigentliche Gleichspannungsquelle 2 zum Versorgen des (nicht gezeigten) Plasmaprozesses mit einer Gleichspannung sowie eine Bogenentladungs-Erkennungseinrichtung 3 auf, die zum Erkennen von Bogenladungen in dem Plasmaprozess signaltechnisch mit der Gleichspannungsquelle 2 innerhalb der Plasma-Leistungsversorgung 1 zusammenwirkt.

Dazu weist die Bogenentladungs-Erkennungseinrichtung 3 einen ersten Eingang 4 für eine elektrische Kenngröße KG der Gleichspannungsquelle 2 auf. Wie dem Fachmann an sich geläufig ist, kann es sich bei der elektrischen Kenngröße KG entweder um eine Spannung oder einen Strom handeln, wobei ein Spannungsabfall bzw. eine Stromerhöhung an der Gleichspannungsquelle 2 anzeigt, dass in dem Plasmaprozess eine Bogenentladung stattfindet oder zumindest im Entstehen begriffen ist.

Die Bogenentladungs-Erkennungseinrichtung 3 umfasst weiterhin eine Überwachungseinheit 5, die signaltechnisch mit dem Eingang 4 verbunden ist. Darüber hinaus weist die Bogenentladungs-Erkennungseinrichtung 3 eine Timer-Einheit 6 sowie eine Steuereinheit 7 auf. Die Steuereinheit 7 besitzt gemäß der Darstellung in Fig. 1 weitere Eingänge 8a - d sowie einen Ausgang 9. Mit dem Ausgang 9 ist die Steuereinheit 7 und damit die Bogenentladungs-Erkennungseinrichtung 3 mit der bereits erwähnten Gleichspannungsquelle 2 signaltechnisch verbunden. Entsprechende Verbindungen bestehen auch zwischen der Überwachungseinheit 5 und der Timer-Einheit 6 sowie von der Überwachungseinheit 5 und der Timer-Einheit 6 zur Steuereinheit 7.

Erfindungsgemäß ist die Überwachungseinheit 5 der Bogenentladungs-Erkennungseinrichtung 3 dazu ausgebildet, die bei 4 eingegebene elektrische Kenngröße der Gleichspannungsquelle 2 zu überwachen, beispielsweise durch Vergleichen mit einem (nicht gezeigten) Referenz- oder Schwellwert, was dem Fachmann an sich geläufig ist. Somit kann die Überwachungseinheit 5 insbesondere dazu ausgebildet sein, einen Abfall der Spannung der Gleichspannungsquelle 2 bzw. einem Anstieg des Stroms der Gleichspannungsquelle 2 durch Vergleich mit einem entsprechenden Referenzwert zu erkennen, was dementsprechend das Vorhandensein oder die Entstehung einer Bogenentladung des Plasmaprozesses anzeigt. Die Überwachungseinheit 5 ist weiterhin dazu ausgebildet, bei Erkennen einer Bogenentladung, wie vorstehend beschrieben, ein entsprechendes Überwachungssignal MS zu erzeugen und insbesondere an die Timer-Einheit 6 auszugeben. Des Weiteren erfolgt die Ausgabe des Überwachungssignales MS bei Erkennen der Bogenentladung auch an die Steuereinheit 7, wie in Fig. 1 dargestellt.

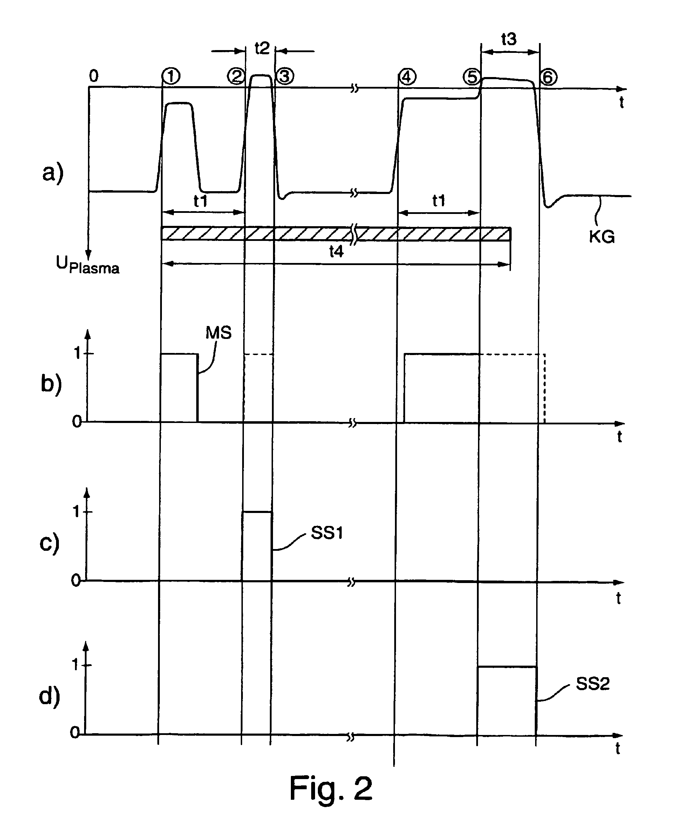

Es sei an dieser Stelle angemerkt, dass im Rahmen der vorliegenden Beschreibung der Begriff "Erzeugen" eines Signals ohne Beschränkung der Allgemeinheit angibt, dass das betreffende Signal auf einen hohen Logikpegel ("1") umgeschaltet wird. Wie der Fachmann erkennt, lässt sich der erfinderische Gedanke jedoch auch mittels alternativer Signalformen verwirklichen, insbesondere indem die betreffenden Signale bei ihrer Erzeugung zumindest teilweise auf einen niedrigen Logikpegel umgeschaltet werden. Hierauf wird weiter unten unter Bezugnahme auf die Figur 2 noch detaillierter eingegangen.

Die Timer-Einheit 6 ist erfindungsgemäß dazu ausgebildet, eine seit Erzeugung des Überwachungssignals MS durch die Überwachungseinheit 5 vergangene Zeit zu bestimmen und das Zeitsignal TS an die Steuereinheit 7 auszugeben, wie in Fig. 1 dargestellt. Somit ist der Steuereinheit 7 nach Maßgabe des Überwachungssignals MS der Überwachungseinheit 5 und des Zeitsignals TS der Timer-Einheit 6 bekannt, ob und gegebenenfalls seit wann in dem Plasmaprozess eine Bogenentladung stattfindet oder in der Entstehung begriffen ist.

Die Steuereinheit 7 ist erfindungsgemäß ihrerseits dazu ausgebildet, in Abhängigkeit von dem anliegenden Überwachungssignal MS und der nach Maßgabe des Zeitsignals TS vergangenen Zeit seit Erkennen einer Bogenentladung wenigstens ein Steuersignal SS zu erzeugen und über den Ausgang 9 zum Steuern der Plasma-Leistungsversorgung 1 hinsichtlich einer betreffenden Gegenmaßnahme zur Unterdrückung der Bogenentladung an die Gleichspannungsquelle 2 auszugeben. Dabei kann es sich bei dem Steuersignal SS insbesondere um ein Signal handeln, durch welches ein Abschalten oder ein Umpolen der Gleichspannungsquelle 2 bewirkbar ist, um auf diese Weise in an sich bekannter Weise eine erkannte Bogenentladung des Plasmaprozesses zu unterdrücken (löschen).

Um hierbei in der Praxis eine Unterscheidung zwischen selbstverlöschenden Short-Arcs und nicht selbstverlöschenden Hard-Arcs realisieren zu können, ist die Steuereinheit 7 weiterhin dazu ausgebildet, ein erstes Steuersignal SS1 für eine erste Gegenmaßnahme zu erzeugen und über den Ausgang 9 an die Gleichspannungsquelle 2 auszugeben, wenn die Überwachungseinheit 5 das Überwachungssignal MS, welches das Erkennen einer Bogenentladung anzeigt, nach Ablauf einer vorgegebenen ersten Zeit, die durch das Zeitsignal TS der Timer-Einheit 6 angezeigt wird, nicht mehr ausgibt. Mit anderen Worten: Wenn das Zeitsignal TS der Timer-Einheit 6 den Ablauf einer vorgegebenen ersten Zeit anzeigt und wenn zu diesem Zeitpunkt das Überwachungssignal MS der Überwachungseinheit 5 nach vormals erkannter Bogenentladung keine Bogenentladung in dem Plasmaprozess mehr anzeigt, d.h. MS = 0, dann gibt die Steuereinheit 7 über den Ausgang 9 das erste Steuersignal SS1 an die Gleichspannungsquelle 2 aus, um auf diese Weise die erste Gegenmaßnahme zu bewirken. Dabei handelt es sich erfindungsgemäß bei einer "Gegenmaßnahme" entweder um das Abschalten der Gleichspannungsquelle 2, d.h. eine Unterbrechung der Plasma-Leistungsversorgung, oder um ein Umpolen der Gleichspannungsquelle 2, um auf diese Weise die Bogenentladung noch effizienter löschen zu können.

Die Tatsache, dass nach Ablauf der ersten Zeit die zuvor erkannte und durch das Überwachungssignal MS Bogenentladung nicht mehr vorhanden ist, bedeutet bei entsprechender Wahl der vorgegebenen ersten Zeit, dass es sich bei der erkannten Bogenentladung um eine selbstverlöschende Bogenentladung, d.h. einen Short-Arc, gehandelt hat. Erfindungsgemäß wird also auch auf einem derartigen Short-Arc mit einer entsprechenden ersten Gegenmaßnahme reagiert, worauf weiter unten anhand der Fig. 2 noch detaillierter eingegangen wird.

Wenn jedoch nach Ablauf der ersten Zeit das Steuersignal MS weiterhin eine Bogenentladung anzeigt, d.h. MS = 1, dann erzeugt die Steuereinheit 7 ein zweites, von dem ersten Steuersignal SS1 verschiedenes, zweites Steuersignal SS2 und gibt dieses über den Ausgang 9 an die Gleichspannungsquelle 2 aus. Durch dieses zweite Steuersignal SS2 wird erfindungsgemäß eine zweite, von der ersten Gegenmaßnahme verschiedene, Gegenmaßnahme zum Unterdrücken der Bogenentladung bewirkt, wie weiter oben bereits ausführlich dargestellt. Mit anderen Worten: Wenn nach Ablauf der ersten Zeit die bereits erkannte Bogenentladung weiterhin stattfindet, handelt es sich dabei um einen nicht selbstverlöschenden Hard-Arc, auf den mit einer speziellen zweiten Gegenmaßnahme reagiert wird. Dabei unterscheiden sich die ersten und zweiten Gegenmaßnahmen vorteilhafter Weise hinsichtlich ihrer jeweiligen Durchführungszeit, wobei insbesondere eine zweite einstellbare Zeit, während der die erste Gegenmaßnahme durch das Steuersignal SS1 bewirkt ist, kürzer ist als eine dritte Zeit, während der die zweite Gegenmaßnahme durch das Steuersignal SS2 bewirkt ist. Die einstellbaren ersten bis dritten Zeiten t1 - t3 sind gemäß der Darstellung in Fig. 1 über jeweilige Eingänge 8a - c in die Steuereinheit 7 ein- und damit vorgebbar.

Über den vierten Eingang 8d der Steuereinheit 7 in Fig. 1 ist noch eine vierte Zeit t4 ein- bzw. vorgebbar, auf die weiter unten bei Erläuterung der Fig. 2 noch detailliert eingegangen wird.

Fig. 2 zeigt ein Zeitablaufdiagramm für Signale innerhalb der Plasma-Leistungsversorgung 1 aus Fig. 1 gemäß einer Ausgestaltung der vorliegenden Erfindung. Die Fig. 2 ist in vier Teile a) bis d) unterteilt, wobei Teil a) exemplarisch den Signalverlauf der elektrischen Kenngröße KG (vgl. Fig. 1), Teil b) einen Signalverlauf des Überwachungssignals MS, Teil c) einen Signalverlauf des ersten Steuersignals SS1 und Teil d) einen Signalverlauf des zweiten Steuersignals SS2 darstellt. Des Weiteren bezeichnet in Fig. 2 t die Zeit und U_{Plasma} eine Plasmaspannung des betrachteten Plasmaprozesses, die vorliegend mit einer durch die Gleichspannungsquelle 2 (Fig. 1) gelieferten Spannung gleichzusetzen ist.

Wie der Fig. 2 zu entnehmen ist, kommt es bei ① zu einem Spannungseinbruch des Plasmaprozesses, der durch eine Bogenentladung bewirkt ist. Vorliegend handelt es sich dabei um einen Short-Arc, der innerhalb einer Zeit t < t1 von selbst wieder verlischt, wie in Fig. 2 bei a) zu entnehmen ist. Mit anderen Worten: Vor Erreichen des Zeitpunkts ②, welcher den Ablauf der ersten Zeit t1 markiert, wechselt das Überwachungssignal MS (Fig. 1) von einem hohen Logikpegel MS = 1 zurück auf einen niedrigen Logikpegel MS = 0. Dennoch bewirkt die Steuereinheit 7 (Fig. 1) zum Zeitpunkt ② für eine Zeit t2, d.h. bis zum Zeitpunkt ③ ein Umpolen der Plasmaspannung. Signalverläufe der entsprechenden Steuersignale sind in Fig. 2 bei b) und c) zu entnehmen. Kurz nachdem die Plasmaspannung, wie bei a) gezeigt, zum Zeitpunkt ① einbricht, d.h. bei Unterschreiten einer bestimmten, nicht gezeigten Spannungsschwelle, gibt die Überwachungseinheit 5 (Fig. 1) das Überwachungssignal MS auf einem hohen Logikpegel MS = 1 aus. Zum Zeitpunkt ② überprüft die Steuereinheit 7 (Fig. 1), ob das Überwachungssignal MS noch mit hohem Logikpegel MS = 1 anliegt. Ist dies vorliegend nicht der Fall, sodass die Steuereinheit 7 - wie bereits beschrieben - gemäß Darstellung bei c) das erste Steuersignal SS1 = 1 ausgibt. Dies geschieht während einer zweiten Zeit t2, während gemäß der Darstellung in Fig. 2 ein Umpolen der Plasmaspannung bewirkt ist. Der Zustand dauert bis zum Zeitpunkt ③, in dem die Steuereinheit 7 das erste Steuersignal SS1 gemäß der Darstellung bei c) wieder auf einen niedrigen Logikpegel SS1 = 0 zurückschaltet. Bei b) in Fig. 2 ist gestrichelt noch ein Zustand des Überwachungssignals MS während der zwischen ② und ③ ergriffenen ersten Gegenmaßnahme zur Unterdrückung der Bogenentladung dargestellt. Dieser Signalverlauf ist jedoch für das Erzeugen des ersten Steuersignals SS1 nicht relevant.

Im rechten Teil der Fig. 2 sind entsprechende Signalverläufe für einen Fall gezeigt, bei dem es sich bei der erkannten Bogenentladung um einen nicht selbstverlöschenden Hard-Arc handelt. Dies ist bei a) in Fig. 2 dadurch gezeigt, dass der zu einem Zeitpunkt ④ auftretende Spannungsabfall bis zum Zeitpunkt ⑤ andauert, wobei das zwischen den Zeitpunkten ④ und ⑤ liegende Zeitintervall wieder der ersten Zeit t1 entspricht. Bei b) ist in Fig. 2 wiederum der entsprechende Signalverlauf des Überwachungssignals MS der Überwachungseinheit 5 (Fig. 1) gezeigt. Entscheidend ist dabei, dass das Überwachungssignal MS zum Zeitpunkt ⑤ immer noch einen hohen Logikpegel MS = 1 aufweist. Entsprechend wird das erste Steuersignal SS1 zum Zeitpunkt ⑤ nicht aktiviert, sondern auf einem niedrigen Logikpegel SS1 = 0 gehalten (vgl. c) in Fig. 2). Dafür wird, wie bei d) in Fig. 2 gezeigt, durch die Steuereinheit 7 (Fig. 1) das zweite Steuersignal SS2 = 1 im Zeitpunkt ⑤ erzeugt und ausgegeben. Dies geschieht während einer dritten Zeit t3, wobei gilt, dass t3 > t2, wie auch der Fig. 2 im oberen Bereich zu entnehmen ist. Das Erzeugen und Ausgeben des zweiten Steuersignals SS2 = 1 während der Zeit t3 zwischen ⑤ und ⑥ bewirkt dementsprechend die zweite Gegenmaßnahme zum Unterdrücken der Bogenentladung, um entsprechend angemessen auf das Auftreten von nicht selbstverlöschenden Hard-Arcs zu reagieren.

Bei b) ist in Fig. 2 wiederum mittels einer gestrichelten Linie der weitere Verlauf des Überwachungssignals MS gezeigt, der jedoch nach dem Zeitpunkt ⑤ für das Erzeugen insbesondere des Steuersignals SS2 ohne besonderen Belang ist.

In Fig. 2 ist bei a) symbolisch mittels eines schraffierten Balkens eine weitere Zeit bzw. ein Zeitintervall t4 dargestellt, deren Wert bzw. Dauer über den bereits erwähnten vierten Eingang 8d der Steuereinheit 7 gemäß Fig. 1 ein- bzw. vorgebbar ist. Durch das Vorgeben der vierten Zeit t4 lässt sich bei einer besonderen Ausgestaltung der vorliegenden Erfindung bewirken, dass nach einem erfolgten Erkennen eines Spannungsabfalls, d.h. einer Bogenentladung bzw. des entsprechenden Ansprechens der Überwachungseinheit 5 (Fig. 1), wie bei b) in Fig. 2 gezeigt, bis zum Ablauf der Zeit t4 kein weiteres erstes Steuersignal SS = 1 (vgl. c) in Fig. 4) erzeugt werden kann. Dies wäre in Abwandlung der Darstellung in Fig. 2 beispielsweise dann von Belang, wenn es sich bei dem Spannungsabfall im Zeitpunkt ④ ebenfalls um einen selbstverlöschenden Short-Arc handeln würde (in Fig. 2 nicht gezeigt). Dann würde zwar das bei b) in Fig. 2 gezeigte Überwachungssignal MS wiederum das Erkennen einer Bogenentladung anzeigen, allerdings würde das erste Steuersignal SS1 analog zur Darstellung bei c) in Fig. 2 auf einem niedrigen Logikpegel verbleiben, obwohl es sich bei der bekannten Bogenentladung um einen Short-Arc handelt. Dies liegt daran, dass der betreffende Zeitpunkt ⑤ zum Auslösen der entsprechenden ersten Gegenmaßnahme noch in das nach Maßgabe der Zeit t4 "gesperrte" Zeitintervall fällt, sodass kein erstes Steuersignal SS1 = 1 erzeugt und ausgegeben wird.

Durch das einstellbare Vorgeben der weiteren, vierten Zeit t4, innerhalb derer auf ein oder mehrere erkannte Short-Arcs nicht reagiert wird, kann die Bearbeitungsrate des betreffenden Plasmaprozesses erhöht werden, wobei entsprechend gelten muss, dass t4 > t1.

Vorteilhafter Weise liegt die zweite Zeit t2, während der erfindungsgemäß auf einen erkannten Short-Arc reagiert wird, im Bereich von 1 bis 10 µs. Dementsprechend ist die dritte Zeit t3 größer als die zweite Zeit t2, d.h. t3 > t2. Für die vierte Zeit t4 gilt - wie gesagt -, dass t4 > t1.

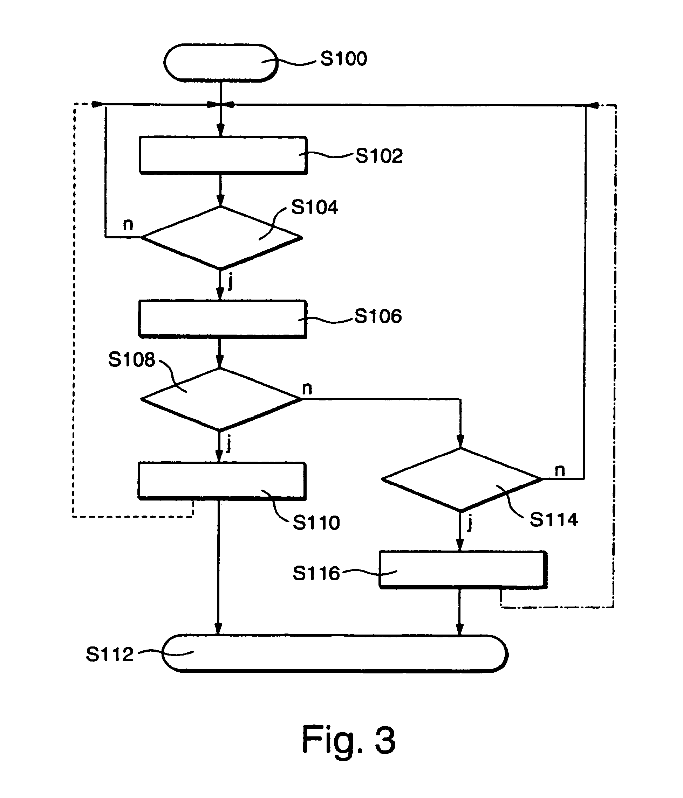

Fig. 3 zeigt ein Flussdiagramm zur Darstellung einer Ausgestaltung des erfindungsgemäßen Verfahrens zum Betreiben eines Plasmaprozesses. Das erfindungsgemäße Verfahren beginnt mit Schritt S100. In einem anschließenden Schritt S102 erfolgt die Überwachung der elektrischen Kenngröße, d.h. der Spannung oder des Stroms, wie vorstehend bereits ausführlich beschrieben.

Anschließend wird in Schritt S104 überprüft, ob anhand der in Schritt S102 überwachten Kenngröße das Auftreten einer Bogenentladung erkennbar ist. Ist dies nicht der Fall (n), kehrt das Verfahren nach Schritt S102 zurück. Wird die Abfrage in Schritt S104 jedoch bejaht (j), so wird während des nachfolgenden Schritts S106 die Zeit t1 abgewartet, wie vorstehend beschrieben. Anschließend wird in Schritt S108 die elektrische Kenngröße erneut auf das Vorliegen einer Bogenentladung überprüft. Wird die Bogenentladung weiterhin erkannt (j), so handelt es sich um einen Hard-Arc, und in Schritt S110 erfolgt während einer vorgegebenen (dritten) Zeit eine entsprechende Gegenmaßnahme, d.h. eine Unterbrechung oder ein Umpolen der Plasma-Leistungsversorgung. Anschließend endet das Verfahren in Schritt S112 oder wird in Schritt S102 fortgesetzt (gestrichelte Linie in Fig. 3).

Wird die Abfrage in Schritt S108 verneint (n), d.h. die zuvor erkannte Bogenentladung ist nach Ablauf der Zeit gemäß Schritt S106 nicht mehr vorhanden, so erfolgt in Schritt S114 eine Überprüfung dahingehend, ob ein eventuell zuvor initialisiertes Zeitintervall zum Blockieren von Reaktionen auf einen Short-Arc (viertes Zeitintervall t4) abgelaufen bzw. inaktiv ist. Ist dies der Fall (j), so erfolgt in Schritt S116 während einer weiteren vorgegebenen (zweiten) Zeit eine entsprechende Gegenmaßnahme zur Unterdrückung von Short-Arcs durch entsprechendes Unterbrechen bzw. Umpolen der Plasma-Leistungsversorgung, wie weiter oben bereits eingehend beschrieben. Anschließend endet das erfindungsgemäße Verfahren wiederum in Schritt S112 oder wird in Schritt S102 fortgesetzt (strichpunktierte Linie in Fig. 3).

Wird dagegen die Abfrage in Schritt S114 verneint (n), d.h. das Intervall t4 ist noch nicht abgelaufen, so erfolgt erfindungsgemäß keine Reaktion auf den erkannten Short-Arc, und das Verfahren kehrt nach Schritt S102 zurück.

Die Erfindung ist anwendbar auf Plasma-Leistungsversorgungen, die Gleichspannung an das Plasma liefern, wie in den Beispielen beschrieben. Darüber hinaus ist die Erfindung auch auf Plasma-Leistungsversorgungen anwendbar, die eine Wechselspannung an das Plasma liefern.

Dabei sind die Begriffe "erste Zeit", "zweite Zeit", "dritte Zeit", "vierte Zeit" und "Timer-Einheit", die zur Beschreibung der vorliegenden Erfindung verwendet werden, sehr weit auszulegen.

Alternativ zu einer fest vorgegebenen Zeit kann die jeweilige Zeit auch automatisch einstellbar sein, z.B. abhängig von der Rate der erkannten Short- oder Hard-Arcs über einen vorgebbaren Zeitraum. Sie kann auch variabel sein in Abhängigkeit von einem Signal, das an einem Eingangspin der Plasma-Leistungsversorgung anliegt, um vom Anwender in eine automatische Abhängigkeit seiner Messungen oder Steuerungen eingebunden zu werden, z.B. einem Signal, welches einen Gasdruck oder eine Art von Gasgemisch anzeigt.

Zusätzlich zu der automatischen Einstellung der Zeit kann es für den Anwender möglich sein, eine maximale Zeit vorzuwählen, die nicht überschritten wird, auch wenn die automatische Zeiteinstellung eine längere Dauer vorsehen würde. Zusätzlich kann eine minimale Zeit vorwählbar sein, die nicht unterschritten wird, auch wenn die automatische Zeiteinstellung eine kürzere Dauer vorsehen würde.

Bei der Vielzahl der Einstellungsmöglichkeiten ist es vorteilhaft, dem Anwender einen oder mehrere Datensätze von besonders vorteilhaften Einstellungen zur Verfügung zu stellen, unter denen er in einfacher Weise auswählen kann. Vorteilhafter Weise besitzt die erfindungsgemäße Bogenentladungs-Erkennungseinrichtung zu diesem Zweck in Weiterbildung eine (nicht gezeigte) Speichereinheit zum Speichern eines oder mehrerer Sätze von voreingestellten Parametern, die die einstellbaren Zeiten und Schwellwerte auf sinnvolle Werte festlegen, damit ein Betrieb ohne Verzögerung möglich ist. Vorteilhafter Weise besitzt eine Ausgestaltung der erfindungsgemäßen Bogenentladungs-Erkennungseinrichtung eine Möglichkeit für den Anwender, solche Datensätze einzugeben bzw. zu laden und abzuspeichern. Vorteilhafter Weise werden diese Datensätze in einem nichtflüchtigen Speicher abgelegt, der die Daten speichert, auch wenn die Bogenentladungs-Erkennungseinrichtung vollständig von jeder Stromversorgung getrennt wird.

Bei der Vielzahl existierender Einstellungsmöglichkeiten ist es vorteilhaft, dem Anwender in Weiterbildung der Erfindung einen oder mehrere Datensätze von besonders vorteilhaften Einstellungen zur Verfügung zu stellen, unter denen er einfach auswählen kann. Vorteilhafter Weise besitzt eine weitere Ausgestaltung der erfindungsgemäßen die Plasma-Leistungsversorgung einen oder mehrere Sätze von voreingestellten Parametern, die die einstellbaren Zeiten und Schwellwerte auf sinnvolle Werte festlegen, damit ein Betrieb ohne Verzögerung möglich ist. Vorteilhafter Weise besitzt die Plasma-Leistungsversorgung eine Möglichkeit, solche Datensätze durch den Anwender abzuspeichern. Vorteilhafter Weise werden diese Datensätze in einem nichtflüchtigen Speicher abgelegt, der die Daten speichert, auch wenn die Plasma-Leistungsversorgung vollständig von jeder Stromversorgung getrennt wird.

Weiterhin besteht die Gefahr, das der Anwender Zeiten bzw. entsprechende Werte eingibt, die sinnlos sind oder dazu führen können, dass die Plasma-Leistungsversorgung nicht arbeitet, weil z.B. eine Zeit viel zu gering oder viel zu groß eingestellt wurde. Das könnte dazu führen, dass kein Signal am Ausgang der Bogenentladungs-Erkennungseinrichtung verfügbar ist. Vorteilhafter Weise wird der Anwender bei dem Versuch, Daten einzugeben, die sinnlos sind oder für den Betrieb schädlich sein können, mit einer Warnmeldung auf die möglichen Gefahren hingewiesen, wozu eine erfindungsgemäße Vorrichtung neben entsprechenden Eingabemitteln (nicht gezeigt) auch entsprechende Ausgabemittel (nicht gezeigt) zum Ausgeben der Warnmeldung aufweist. Völlig unsinnige Einstellungen können in Weiterbildung der vorliegenden Erfindung auch unterbunden werden.

Die überwachte Kenngröße ist - wie gesagt - vorzugsweise eine elektrische Kenngröße, wie in den Beispielen beschrieben. Sie kann aber auch eine beliebige andere geeignete Kenngröße aus dem Bereich des Plasmaprozesses sein.

## Patentansprüche

1. Verfahren zum Erkennen von Bogenentladungen in einem Plasmaprozess, bei dem zum Erkennen auftretender Bogenentladungen in dem Plasma eine Kenngröße (KG) des Plasmaprozesses überwacht wird, und bei dem nach Erkennen einer Bogenentladung während einer ersten Zeit (t1) abgewartet und anschließend die Kenngröße erneut überprüft wird, **dadurch gekennzeichnet, dass** als Reaktion auf den Fall, dass nach Ablauf der ersten Zeit (t1) keine Bogenentladung erkannt wird, eine erste Gegenmaßnahme zum Unterdrücken von Bogenentladungen durchgeführt wird.

2. Verfahren nach Anspruch 1, wobei dass Verfahren zum Steuern des Betriebs einer Plasma-Leistungsversorgung (1) eingesetzt wird.

3. Verfahren nach Anspruch 1 oder 2, wobei eine elektrische Kenngröße (KG) des Plasmaprozesses überwacht wird.

4. Verfahren nach einem der Ansprüche 1 bis 3, wobei die erste Gegenmaßnahme während einer zweiten Zeit (t2) durchgeführt wird.

5. Verfahren nach Anspruch 4, wobei die zweite Zeit (t2) zwischen 0,1 und 10 µs beträgt.

6. Verfahren nach einem der Ansprüche 1 bis 4, wobei als erste Gegenmaßnahme ein Unterbrechen oder ein Umpolen einer Plasma-Leistungsversorgung (1) durchgeführt wird.

7. Verfahren nach einem der Ansprüche 1 bis 6, wobei in dem Fall, dass nach Ablauf der ersten Zeit (t1) weiterhin eine Bogenentladung erkannt wird, eine zweite Gegenmaßnahme zum Unterdrücken von Bogenentladungen durchgeführt wird.

8. Verfahren nach Anspruch 7, wobei die zweite Gegenmaßnahme während einer dritten Zeit (t3) durchgeführt wird.

9. Verfahren nach Anspruch 7 oder 8, wobei als zweite Gegenmaßnahme ein Unterbrechen oder ein Umpolen einer Plasma-Leistungsversorgung (1) durchgeführt wird.

10. Verfahren nach Anspruch 8 oder 9, wobei die dritte Zeit (t3) länger als die zweite Zeit (t2) und vorzugsweise länger als 10 µs ist.

11. Verfahren nach einem der Ansprüche 1 bis 10, wobei während der ersten Zeit (t1) keine Reaktion auf weitere erkannte Bogenentladungen erfolgt.

12. Verfahren nach einem der Ansprüche 1 bis 11, wobei während einer vierten Zeit (t4) ab Erkennen der Bogenentladung keine weiteren ersten Gegenmaßnahmen durchgeführt werden, wobei die vierte Zeit vorzugsweise länger ist als die erste Zeit (t1).

13. Bogenentladungs-Erkennungseinrichtung (3) zum Erkennen von Bogenentladungen in einem Plasmaprozess anhand einer Kenngröße (KG) des Plasmaprozesses, bei der die Bogenentladungs-Erkennungseinrichtung aufweist:
- eine Überwachungseinheit (5) zum Überwachen der Kenngröße, die zum Erzeugen und Ausgeben eines Überwachungssignals (MS) bei Erkennen einer Bogenentladung ausgebildet ist;
- eine Timer-Einheit (6), die zum Bestimmen und Ausgeben einer seit Erzeugung des Überwachungssignals vergangenen Zeit (t) ausgebildet ist;
- eine Steuereinheit (7), die dazu ausgebildet ist, in Abhängigkeit von dem Überwachungssignal und der vergangenen Zeit wenigstens ein Steuersignal (SS1, SS2) zum Steuern einer jeweiligen Gegenmaßnahme zum Unterdrücken der Bogenentladung zu erzeugen,
**dadurch gekennzeichnet, dass** die Steuereinheit dazu ausgebildet ist, ein erstes Steuersignal (SS1) zum Veranlassen einer ersten Gegenmaßnahme zu erzeugen, wenn die Überwachungseinheit (5) das Überwachungssignal (MS) für das Erkennen der Bogenentladung nach Ablauf einer ersten vorgegebenen Zeit (t1) nicht mehr ausgibt.

14. Bogenentladungs-Erkennungseinrichtung (3) nach Anspruch 13, wobei die Steuereinheit (7) zum Ausgeben des ersten Steuersignals (SS1) während einer zweiten Zeit (t2) ausgebildet ist.

15. Bogenentladungs-Erkennungseinrichtung (3) nach Anspruch 14, wobei die zweite Zeit (t2) einstellbar ist und insbesondere zwischen 0,1 und 10 µs beträgt.

16. Bogenentladungs-Erkennungseinrichtung (3) nach einem der Ansprüche 13 bis 15, wobei die Steuereinheit (7) dazu ausgebildet ist, ein zweites Steuersignal (SS2) für eine zweite Gegenmaßnahme zu erzeugen, wenn die Überwachungseinheit (5) das Überwachungssignal (MS) für das Erkennen der Bogenentladung nach Ablauf der ersten Zeit (t1) weiterhin ausgibt.

17. Bogenentladungs-Erkennungseinrichtung (3) nach Anspruch 16, wobei die Steuereinheit (7) zum Ausgeben des zweiten Steuersignals (SS2) während einer dritten Zeit (t3) ausgebildet ist.

18. Bogenentladungs-Erkennungseinrichtung (3) nach Anspruch 17, wobei die dritte Zeit (t3) einstellbar ist, insbesondere auf Werte größer als die zweite Zeit (t2).

19. Bogenentladungs-Erkennungseinrichtung (3) nach einem der Ansprüche 13 bis 18, wobei die Steuereinheit (7) dazu ausgebildet ist, das erste Steuersignal (SS1) vor Ablauf einer vierten Zeit (t4) ab Erkennen der Bogenentladung nicht erneut zu erzeugen.

20. Bogenentladungs-Erkennungseinrichtung (3) nach Anspruch 19, wobei die vierte Zeit einstellbar ist, insbesondere auf Werte größer als die erste Zeit (t1).

21. Bogenentladungs-Erkennungseinrichtung (3) nach einem der Ansprüche 13 bis 20, wobei die Überwachungseinheit (5) zum Überwachen einer elektrischen Kenngröße (KG) des Plasmaprozesses ausgebildet ist.

22. Plasma-Leistungsversorgung (1) zum Versorgen eines Plasmaprozesses, **gekennzeichnet durch** eine Bogenentladungs-Erkennungseinrichtung (3) nach einem der Ansprüche 13 bis 21, wobei die Plasma-Leistungsversorgung **durch** die Steuereinheit (7) der Bogenentladungs-Erkennungseinrichtung steuerbar ist.

23. Plasma-Leistungsversorgung (1) nach Anspruch 22, wobei die Plasma-Leistungsversorgung als erste Gegenmaßnahme zum Unterdrücken von Bogenentladungen nach Maßgabe eines ersten Steuersignals (SS1) der Steuereinheit (7) während einer bestimmten Zeit (t2) abschaltbar oder umpolbar ist.

24. Plasma-Leistungsversorgung (1) nach Anspruch 22 oder 23, wobei die Plasma-Leistungsversorgung als zweite Gegenmaßnahme zum Unterdrücken von Bogenentladungen nach Maßgabe eines zweiten Steuersignals (SS2) der Steuereinheit (7) während einer weiteren bestimmten Zeit (t3) abschaltbar oder umpolbar ist.

## Claims

1. A method for the detection of arc discharges in a plasma process, in which for the detection of arc discharges occurring in the plasma a parameter (KG) of the plasma process is monitored, and in which after detection of an arc discharge a first period of time (t1) is allowed to elapse and the parameter is subsequently rechecked, **characterised in that** in response to the event that after elapse of the first period of time (t1) no arc discharge is detected, a first countermeasure for the suppression of arc discharges is executed.

2. The method according to claim 1, wherein the method is used to control the operation of a plasma power supply (1).

3. The method according to claim 1 or 2, wherein an electrical parameter (KG) of the plasma process is monitored.

4. The method according to one of the claims 1 to 3, wherein the first countermeasure is executed during a second period of time (t2).

5. The method according to claim 4, wherein the second period of time (t2) is between 0.1 and 10 µs in duration.

6. The method according to one of the claims 1 to 4, wherein an interruption or a reversal in polarity of a plasma power supply (1) is executed as a first countermeasure.

7. The method according to one of the claims 1 to 6, wherein in the event that after elapse of the first period of time (t1) an arc discharge is still detected, a second countermeasure for the suppression of arc discharges is executed.

8. The method according to claim 7, wherein the second countermeasure is executed during a third period of time (t3).

9. The method according to claim 7 or 8, wherein an interruption or a reversal in polarity of a plasma power supply (1) is executed as a second countermeasure.

10. The method according to claim 8 or 9, wherein the third period of time (t3) is longer than the second period of time (t2) and is preferably longer than 10 µs.

11. The method according to one of the claims 1 to 10, wherein no response to any further arc discharges detected takes place during the first period of time (t1).

12. The method according to one of the claims 1 to 11, wherein during a fourth period of time (t4) from the detection of the arc discharge no further first countermeasures are executed, wherein the fourth period of time is preferably longer than the first period of time (t1).

13. An arc discharge detection device (3) for the detection of arc discharges in a plasma process with the aid of a parameter (KG) of the plasma process, in which the arc discharge detection device has:
- a monitoring unit (5) to monitor the parameter, which is configured to generate and output a monitoring signal (MS) in the event of detection of an arc discharge;
- a timer unit (6), which is configured to determine and output a time (t) that has elapsed since generation of the monitoring signal;
- a control unit (7), which is configured so as to generate as a function of the monitoring signal and the elapsed time at least one control signal (SS1, SS2) to control a respective countermeasure for the suppression of the arc discharge,
**characterised in that** the control unit is configured so as to generate a first control signal (SS1) to trigger a first countermeasure, if the monitoring unit (5) no longer outputs the monitoring signal (MS) for the detection of the arc discharge after elapse of a first pre-defined period of time (t1).

14. The arc discharge detection device (3) according to claim 13, wherein the control unit (7) is configured to output the first control signal (SS1) during a second period of time (t2).

15. The arc discharge detection device (3) according to claim 14, wherein the second period of time (t2) is adjustable and in particular is between 0.1 and 10 µs in duration.

16. The arc discharge detection device (3) according to one of the claims 13 to 15, wherein the control unit (7) is configured so as to generate a second control signal (SS2) for a second countermeasure if the monitoring unit (5) continues to output the monitoring signal (MS) for the detection of the arc discharge after elapse of the first period of time (t1).

17. The arc discharge detection device (3) according to claim 16, wherein the control unit (7) is configured to output the second control signal (SS2) during a third period of time (t3).

18. The arc discharge detection device (3) according to claim 17, wherein the third period of time (t3) is adjustable, in particular to values greater than the second period of time (t2).

19. The arc discharge detection device (3) according to one of the claims 13 to 18, wherein the control unit (7) is configured so as not to regenerate the first control signal (SS1) before the elapse of a fourth period of time (t4) from the detection of the arc discharge.

20. The arc discharge detection device (3) according to claim 19, wherein the fourth period of time is adjustable, in particular to values greater than the first period of time (t1).

21. The arc discharge detection device (3) according to one of the claims 13 to 20, wherein the monitoring unit (5) is configured to monitor an electrical parameter (KG) of the plasma process.

22. A plasma power supply (1) to supply a plasma process, **characterised by** an arc discharge detection device (3) according to one of the claims 13 to 21, wherein the plasma power supply can be controlled by the control unit (7) of the arc discharge detection device.

23. The plasma power supply (1) according to Claim 22, wherein the plasma power supply can be switched off or reversed in polarity as a first countermeasure for the suppression of arc discharges compliant with a first control signal (SS1) of the control unit (7) during a certain period of time (t2).

24. The plasma power supply (1) according to claim 22 or 23, wherein the plasma power supply can be switched off or reversed in polarity as a second countermeasure for the suppression of arc discharges compliant with a second control signal (SS2) of the control unit (7) during a further certain period of time (t3).

## Revendications

1. Procédé de détection de décharges en arc dans un procédé plasma, dans lequel, pour détecter des décharges en arc se produisant dans le plasma, une grandeur caractéristique (KG) du procédé plasma est surveillée, et dans lequel, après détection d'une décharge en arc, la grandeur caractéristique est de nouveau vérifiée après attente pendant un premier temps (t1), **caractérisé en ce qu'**en réaction au cas dans lequel aucune décharge en arc n'est détectée après expiration du premier temps (t1), une première contre-mesure en vue de supprimer les décharges en arc est appliquée.

2. Procédé selon la revendication 1, lequel procédé est utilisé pour commander le fonctionnement d'une alimentation de puissance de plasma (1).

3. Procédé selon la revendication 1 ou 2, dans lequel une grandeur caractéristique électrique (KG) du procédé plasma est surveillée.

4. Procédé selon une des revendications 1 à 3, dans lequel la première contre-mesure est appliquée pendant un deuxième temps (t2).

5. Procédé selon la revendication 4, dans lequel le deuxième temps (t2) est compris entre 0,1 et 10 µs.

6. Procédé selon une des revendications 1 à 4, dans lequel la première contre-mesure consiste en une interruption ou une inversion de polarité d'une alimentation de puissance de plasma (1).

7. Procédé selon une des revendications 1 à 6, dans lequel, dans le cas où une décharge en arc est toujours détectée après expiration du premier temps (t1), une deuxième contre-mesure en vue de supprimer les décharges en arc est appliquée.

8. Procédé selon la revendication 7, dans lequel la deuxième contre-mesure est appliquée pendant un troisième temps (t3).

9. Procédé selon la revendication 7 ou 8, dans lequel la deuxième contre-mesure consiste en une interruption ou une inversion de polarité d'une alimentation de puissance de plasma (1).

10. Procédé selon la revendication 8 ou 9, dans lequel le troisième temps (t3) est plus long que le deuxième temps (t2) et de préférence plus long que 10 µs.

11. Procédé selon une des revendications 1 à 10, dans lequel la détection de décharges en arc supplémentaires pendant le premier temps (t1) ne provoque aucune réaction.

12. Procédé selon une des revendications 1 à 11, dans lequel aucune première contre-mesure supplémentaire n'est appliquée pendant un quatrième temps (t4) à partir de la détection de la décharge en arc, le quatrième temps étant de préférence plus long que le premier temps (t1).

13. Dispositif de détection de décharges en arc (3) destiné à détecter des décharges en arc dans un procédé plasma à l'aide d'une grandeur caractéristique (KG) du procédé plasma, lequel dispositif de détection de décharges en arc présente :
- une unité de surveillance (5) pour surveiller la grandeur caractéristique, qui est conçue pour générer et délivrer un signal de surveillance (MS) en cas de détection d'une décharge en arc ;
- une unité de minuterie (6) qui est conçue pour déterminer et émettre un temps (t) écoulé depuis la génération du signal de surveillance ;
- une unité de commande (7) qui est conçue pour générer au moins un signal de commande (SS1, SS2) destiné à commander une contre-mesure respective pour supprimer la décharge en arc en fonction du signal de surveillance et du temps écoulé,
**caractérisé en ce que** l'unité de commande est conçue pour générer un premier signal de commande (SS1) pour déclencher une première contre-mesure quand l'unité de surveillance (5) ne délivre plus le signal de surveillance (MS) pour la détection de la décharge en arc après expiration d'un premier temps (t1) prédéfini.

14. Dispositif de détection de décharges en arc (3) selon la revendication 13, dans lequel l'unité de commande (7) est conçue pour délivrer le premier signal de commande (SS1) pendant un deuxième temps (t2).

15. Dispositif de détection de décharges en arc (3) selon la revendication 14, dans lequel le deuxième temps (t2) est réglable et en particulier compris entre 0,1 et 10 µs.

16. Dispositif de détection de décharges en arc (3) selon une des revendications 13 à 15, dans lequel l'unité de commande (7) est conçue pour générer un deuxième signal de commande (SS2) pour une deuxième contre-mesure quand l'unité de surveillance (5) continue de délivrer le signal de surveillance (MS) pour la détection de la décharge en arc après expiration du premier temps (t1).

17. Dispositif de détection de décharges en arc (3) selon la revendication 16, dans lequel l'unité de commande (7) est conçue pour délivrer le deuxième signal de commande (SS2) pendant un troisième temps (t3).

18. Dispositif de détection de décharges en arc (3) selon la revendication 17, dans lequel le troisième temps (t3) est réglable, en particulier à des valeurs plus grandes que le deuxième temps (t2).

19. Dispositif de détection de décharges en arc (3) selon une des revendications 13 à 18, dans lequel l'unité de commande (7) est conçue pour ne pas générer de nouveau le premier signal de commande (SS1) avant expiration d'un quatrième temps (t4) à partir de la détection de la décharge en arc.

20. Dispositif de détection de décharges en arc (3) selon la revendication 19, dans lequel le quatrième temps est réglable, en particulier à des valeurs plus grandes que le premier temps (t1).

21. Dispositif de détection de décharges en arc (3) selon une des revendications 13 à 20, dans lequel l'unité de surveillance (5) est conçue pour surveiller une grandeur caractéristique électrique (KG) du procédé plasma.

22. Alimentation de puissance de plasma (1) pour alimenter un procédé plasma, **caractérisée par** un dispositif de détection de décharges en arc (3) selon une des revendications 13 à 21, laquelle alimentation de puissance de plasma peut être commandée par l'unité de commande (7) du dispositif de détection de décharges en arc.

23. Alimentation de puissance de plasma (1) selon la revendication 22, laquelle alimentation de puissance de plasma peut être coupée ou sa polarité inversée pendant un temps défini (t2) en fonction d'un premier signal de commande (SS1) de l'unité de commande (7) comme première contre-mesure pour supprimer les décharges en arc.

24. Alimentation de puissance de plasma (1) selon la revendication 22 ou 23, laquelle alimentation de puissance de plasma peut être coupée ou sa polarité inversée pendant un temps défini supplémentaire (t3) en fonction d'un deuxième signal de commande (SS2) de l'unité de commande (7) comme deuxième contre-mesure pour supprimer les décharges en arc.
